# EUROPÄISCHE PATENTSCHRIFT

(11) **EP 2 630 270 B1**
(45) Veröffentlichungstag und Bekanntmachung des Hinweises auf die Patenterteilung: **15.12.2021**
(21) Anmeldenummer: 11776732.7
(22) Anmeldetag: 18.10.2011
(51) Int. Cl.: C04B 35/01, C23C 14/08, C23C 14/32, C04B 35/111, C04B 35/117, C04B 35/16, C04B 35/56, C04B 35/58

(54) **TARGET FÜR LICHTBOGENVERFAHREN**
TARGET FOR ARC PROCESSES
CIBLE POUR PROCÉDÉ À L'ARC ÉLECTRIQUE

(30) Priorität: 22.10.2010 DE 102010042828
(43) Veröffentlichungstag der Anmeldung: 28.08.2013
(73) Patentinhaber: Walter AG, 72072 Tübingen (DE)
(72) Erfinder: SCHIER, Veit, 70771 Echterdingen (DE)
(74) Vertreter: WSL Patentanwälte Partnerschaft mbB
(86) Internationale Anmeldenummer: PCT/EP2011/068189
(87) Internationale Veröffentlichungsnummer: WO 2012/052437

(56) Entgegenhaltungen:
- EP-A1- 1 722 003
- EP-A1- 1 726 686
- WO-A1-2010/020362
- JP-A- 2008 056 957
- JP-A- 2008 106 287
- JP-A- 2008 163 413
- US-A- 4 923 764
- US-A1- 2009 166 188

## Beschreibung

### Gegenstand der Erfindung

Die vorliegende Erfindung betrifft ein Target und dessen Verwendung für das Abscheiden von Mischkristallschichten aus Aluminium-Chrom-Oxid auf einem Substrat mittels Lichtbogenverdampfen, wobei das Target aus Aluminiumoxid und elementarem Chrom oder aus Aluminiumnitrid und elementarem Chrom oder aus Aluminiumoxid und einer Kombination aus elementarem Chrom und einer keramischen Verbindung von Chrom besteht. Des weiteren betrifft die Erfindung ein Abscheidungsverfahren unter Verwendung solcher Targets.

### Hintergrund der Erfindung

Bei der Bearbeitung von Materialien, insbesondere der spanabhebenden Metallbearbeitung, werden hohe Anforderungen an die entsprechenden Werkzeuge gestellt. Dazu gehören hohe Verschleißbeständigkeit und je nach Anwendungsfall entsprechende Härte, Zähigkeit und Temperaturbeständigkeit des Werkzeugs. Um diese Eigenschaften bereitzustellen, werden in der Regel Werkzeuge aus einem Grundkörper (Substrat) aus Hartmetall, Cermet, Stahl oder Schnellarbeitsstahl mit einer Beschichtung aus metallischen Hartstoffen, Oxidschichten oder dergleichen mit hoher Verschleißbeständigkeit und geeigneten Haftungs- und Schneideigenschaften versehen. Diese Beschichtungen können im CVD-Verfahren (chemische Gasphasenabscheidung) oder PVD-Verfahren (physikalische Gasphasenabscheidung) aufgebracht werden. Bei den PVD-Verfahren werden unterschiedliche Varianten zur Verdampfung des abzuscheidenden Materials verwendet. Für die Beschichtung von Werkzeugen werden häufig PVD-Verfahren mit Kathodenzerstäubung (Sputter-Abscheidung), Lichtbogenverdampfen (Arc-PVD), Magnetron-Sputtern, reaktives Magnetron-Sputtern und High Power Impulse Magnetron-Sputtern (HIPIMS) angewendet.

Ein Vorteil der Magnetron-Sputter-Verfahren besteht darin, dass bei der Verdampfung bzw. Sublimierung des Targets eine feine Ablösung von Teilchen erfolgt, die eine gleichmäßige Beschichtung liefert. Ein Nachteil dieses Verfahrens besteht jedoch darin, dass der notwendige Prozessgasfluss schwierig zu regeln ist. Darüber hinaus werden bei der Abscheidung von Aluminiumoxidschichten im Magnetron-Sputter-Verfahren mit Nachteil nur relativ geringe Anteile der besonders bevorzugten verschleißfesten Alpha-Phase abgeschieden.

Im Gegensatz dazu ist es möglich, bei der PVD-Beschichtung im Lichtbogenverfahren (Arc-PVD) aufgrund hoher Ionenenergien bei der Abscheidung von Aluminiumoxidschichten einen hohen Anteil der Alpha-Phase in der Beschichtung zu erzielen. Bei diesem Verfahren erzeugt der Lichtbogen auf dem Target sehr hohe Temperaturen in der Größenordnung mehrerer tausend Grad Celsius, die zu dem gewünschten Verdampfen bzw. Sublimieren des Targetmaterials für eine Abscheidung auf dem Substrat führen. Um den Auftreffpunkt des Lichtbogens herum entstehen jedoch Zonen niedrigerer Temperatur beispielsweise im Bereich von 500 bis 1000 °C, in denen es bei einigen Targetmetallen zur Ablösung von Makropartikeln, so genannten Droplets, kommt, die ebenfalls auf dem Substrat mit abgeschieden werden. Derartige Droplets sind für eine uner-wünschte Rauheit der abgeschiedenen Schicht im Vergleich zu durch Magnetron-Sputtern erzeugten Schichten verantwortlich. Zudem bewirken die Droplets eine Schwächung der Beschichtung, da sie in der Regel überwiegend rein metallisch sind und damit eine geringe Härte und Oxidationsneigung zeigen.

US 4,923,764 beschreibt die Herstellung dekorativer und/oder vor Korrosion und Abrieb schützender Beschichtungen auf der Oberfläche von Gegenständen mittels Sputterverfahren, Vakuumabscheidung oder Ionenplattierung von Targets, welche elementares Chrom oder die Legierung Nichrom (Ni+Cr) und Aluminiumoxid entweder im selben Target oder in separaten Targets enthalten.

US 2009/166188 beschreibt die Abscheidung von gering leitfähigen oder isolierenden Schichten aus Aluminium-Chrom-Oxid in einem Lichtbogenverfahren von einem Target aus einer Aluminium-Chrom-Legierung.

### Aufgabe

Die Aufgabe der vorliegenden Erfindung bestand darin, Mischkristallschichten aus Aluminium-Chrom-Oxid auf einem Substrat mittels PVD-Verfahren abzuscheiden, die möglichst frei sind von Makropartikeln (Droplets).

### Beschreibung der Erfindung

Diese Aufgabe wird erfindungsgemäß gelöst durch die Verwendung eines Targets, welches aus Aluminiumoxid und elementarem Chrom oder Aluminiumnitrid und elementarem Chrom oder aus Aluminiumoxid und einer Kombination aus elementarem Chrom und einer keramischen Verbindung von Chrom besteht, für das Abscheiden von Mischkristallschichten aus Aluminium-Chrom-Oxid auf einem Substrat mittels Lichtbogenverdampfen.

Die Erfindung umfasst auch ein Target für das Abscheiden von Mischkristallschichten aus Aluminium-Chrom-Oxid auf einem Substrat mittels Lichtbogenverdampfen, wobei das Target aus Aluminiumoxid und einer Kombination aus elementarem Chrom und einer keramischen Verbindung von Chrom besteht, wobei das Chrom in dem Target neben der elementaren Form in einem Anteil von bis zu 70 at-%, bezogen auf das Metall Chrom, in einer keramischen Verbindung vorliegt, nämlich als ein Metalloxid, Metallcarbid, Metallnitrid, Metallcarbonitrid, Metalloxinitrid, Metalloxicarbid, Metalloxicarbonitrid, Metallborid, Metallboronitrid, Metallborocarbid, Metallborocarbonitrid, Metallborooxinitrid, Metallborooxocarbid, Metallborooxocarbonitrid, Metalloxoboronitrid, Metallsilicat oder Gemisch davon, vorzugsweise als Chromnitrid, oder wobei das Target aus Aluminiumnitrid und elementarem Chrom besteht.

Bei dem erfindungsgemäßen Target liegt das Metall mit der niedrigsten Schmelztemperatur, nämlich Aluminium, in einer keramischen Verbindung vor, nämlich als Aluminiumoxid (Al₂O₃) oder Aluminiumnitrid (AIN), und hat daher einen deutlich höheren Schmelzpunkt als das reine Metall. Hierdurch wird vermindert bzw. verhindert, dass das Metall um den kälteren Randbereich des Auftreffpunkts des Lichtbogens herum als geschmolzene Makropartikel bzw. Droplets abgelöst wird. Das Problem der Dropletbildung tritt bei hochschmelzenden Targetmaterialien deutlich vermindert oder gar nicht auf. Durch das erfindungsgemäße Target kann eine deutliche Verbesserung der Beschichtungsqualität und eine erhebliche Verminderung der Dropletbildung erzielt werden.

Erfindungsgemäß sind die Metalle in dem Target nur Aluminium und Chrom, wobei Aluminium das niedrigschmelzende Metall mit einer Schmelztemperatur von etwa 660 °C und Chrom das hochschmelzende Metall mit einer Schmelztemperatur von etwa 1860 °C ist. Die hierin angegebenen Schmelztemperaturen gelten unter Standardbedingungen, d.h. bei einem Luftdruck von 1,013 bar, und beziehen sich soweit nicht anders angegeben auf die reinen Metalle.

In einer bevorzugten Ausführungsform der Erfindung besteht das Target aus Aluminiumoxid und metallischem Chrom. Alternativ besteht das Target aus Aluminiumoxid und einer Kombination aus metallischem Chrom und einer keramischen Verbindung von Chrom, insbesondere Chromnitrid.

In einer bevorzugten Ausführungsform der Erfindung ist das in dem Target in einer der keramischen Verbindungen Aluminiumoxid oder Aluminiumnitrid vorliegende Aluminium in dem Target in einer Menge von 2 bis 99 at-% enthalten. Bei niedrigerem Anteil an Aluminium in dem Target wird zu wenig Aluminium in die herzustellende Beschichtung eingebracht. Die Dropletbildung stellt bei zu niedrigem Anteil des Aluminiums auch dann kein relevantes Problem dar, wenn das Aluminium in der elementaren (metallischen) Form vorliegt. Vorzugsweise ist das in dem Target in einer keramischen Verbindung vorliegende Aluminium in dem Target in einer Menge von 5 bis 90 at-% oder von 10 bis 80 at-% oder von 20 bis 70 at-% oder von 30 bis 60 at-% enthalten.

In einer Ausführungsform der Erfindung kann das höherschmelzende Metall Chrom in dem Target, wenn es neben der elementaren (metallischen) Form auch in einer keramischen Verbindung vorliegt, in einem Anteil von bis zu 10 at-%, bezogen auf das Metall Chrom, vorliegen, nämlich als ein Metalloxid, Metallcarbid, Metallnitrid, Metallcarbonitrid, Metalloxinitrid, Metalloxicarbid, Metalloxicarbonitrid, Metallborid, Metallboronitrid, Metallborocarbid, Metallborocarbonitrid, Metallborooxinitrid, Metallborooxocarbid, Metallborooxocarbonitrid, Metalloxoboronitrid, Metallsilicat oder Gemisch davon. In weiteren Ausführungsformen der Erfindung liegt das höherschmelzen-den Metall Chrom in dem Target neben der elementaren (metallischen) Form auch in einem Anteil von bis zu 20 at-% oder bis zu 30 at-% oder bis zu 40 at-% oder bis zu 50 at-% oder bis zu 60 at-% oder bis zu 70 at-%, bezogen auf das Metall Chrom, in einer entsprechenden keramischen Verbindung vor.

Das erfindungsgemäße Target kann nach jedem für die Targetherstellung bekannten und geeigneten Verfahren hergestellt werden, vorzugsweise durch heißisostatisches Pressen.

Die Erfindung umfasst auch ein Verfahren zum Abscheiden von Mischkristallschichten aus Aluminium-Chrom-Oxid auf einem Substrat mittels Lichtbogenverdampfen, bei dem man wenigstens ein Target der hierin beschriebenen erfindungsgemäßen Art verwendet.

Das erfindungsgemäße Verfahren wird vorzugsweise eingesetzt zur Herstellung eines Schneidwerkzeugs mit einem Substrat und einer darauf aufgebrachten ein- oder mehrlagigen Beschichtung, wobei wenigstens eine Schicht der mehrlagigen Beschichtung eine nach dem vorgenannten erfindungsgemäßen Verfahren hergestellte Mischkristallschicht aus Aluminium-Chrom-Oxid ist.

Das Substrat des Schneidwerkzeugs für die erfindungsgemäße Abscheidung der Mischkristallschichten besteht vorzugsweise aus Hartmetall, Cermet, Stahl oder Schnellarbeitsstahl (HSS). Besonders bevorzugt ist das Substrat aus Hartmetall oder Cermet hergestellt.

Das Schneidwerkzeug mit der aufgebrachten Mischkristallschicht hat den Vorteil, dass die Schicht ein besonders hohes Maß an Kristallinität und einen geringen Anteil an abgeschiedenen Makropartikeln (Droplets) aufweist. Im System der Aluminium-Chrom-Mischoxide, abgeschieden mit einem Aluminium und Chrom enthaltenden Target der zuvor beschriebenen Art, und vergleichbaren Systemen mit ähnlicher Kristallstruktur erhält man unter Anwendung des erfindungsgemäßen Verfahrens einen besonders hohen Anteil der thermodynamisch stabilen Alpha-Phase des Mischkristalls. Die Vorteile sind hohe Härte, hohe Verschleißbeständigkeit, hohe Temperaturbeständigkeit und hohe Temperaturwechselbeständigkeit.

### Beispiele

Auf Hartmetallsubstraten mit spiegelpolierter Oberfläche wurden mittels reaktivem Lichtbogenverdampfen (Arc-PVD) bei 160 Ampere unter Verwendung von Sauerstoff als Reaktivgas bei einem Druck von 1,8 Pa und von erfindungsgemäßen Targets sowie Vergleichstargets Metalloxidschichten abgeschieden. Anschließend wurde im Rasterelektronenmikroskop die Häufigkeit auftretender Makropartikel (Dropletdichte) untersucht. Für die Bestimmung der Dropletdichte wurde unter dem Rasterelektronenmikroskop bei 4000-facher Vergrößerung die Anzahl an Droplets mit einem Durchmesser von wenigstens 1 µm auf einer Fläche von 100 µm × 100 µm auf den abgeschiedenen dünnen Lagen ausgezählt. Für jedes Beispiel und Vergleichsbeispiel wurden Dreifachbestimmungen durchgeführt und der Mittelwert angegeben.

### Beispiel 1

| | |
|---|---|
| Target: | Al₂O₃/Cr (AI:Cr = 50:50; Rundquelle Ø 160 mm) |
| abgeschiedene Lage: | Aluminium-Chrom-Oxid |
| Dropletdichte: | 1 Droplet |

### Vergleichsbeispiel 1

| | |
|---|---|
| Target: | AI (Rundquelle Ø 160 mm) |
| abgeschiedene Lage: | Aluminiumoxid |
| Dropletdichte: | 14 Droplets |

### Vergleichsbeispiel 2

| | |
|---|---|
| Target: | Al/Cr (AI:Cr = 50:50; Rundquelle Ø 160 mm) |
| abgeschiedene Lage: | Aluminium-Chrom-Oxid |
| Dropletdichte: | 9 Droplets |

## Patentansprüche

1. Verwendung eines Targets, welches aus Aluminiumoxid und elementarem Chrom oder aus Aluminiumnitrid und elementarem Chrom oder aus Aluminiumoxid und einer Kombination aus elementarem Chrom und einer keramischen Verbindung von Chrom besteht, für das Abscheiden von Mischkristallschichten aus Aluminium-Chrom-Oxid auf einem Substrat mittels Lichtbogenverdampfen.

2. Verwendung nach Anspruch 1, **dadurch gekennzeichnet, dass** das in dem Target in einer der keramischen Verbindungen Aluminiumoxid oder Aluminiumnitrid vorliegende Aluminium in dem Target in einer Menge von 2 bis 99 at-%, vorzugsweise von 5 bis 90 at-% oder von 10 bis 80 at-% oder von 20 bis 70 at-% oder von 30 bis 60 at-% vorliegt.

3. Verwendung nach einem der vorangehenden Ansprüche, **dadurch gekennzeichnet, dass** das Chrom in dem Target, wenn es neben der elementaren Form auch in einer keramischen Verbindung vorliegt, in einem Anteil von bis zu 10 at-% oder bis zu 20 at-% oder bis zu 30 at-% oder bis zu 40 at-% oder bis zu 50 at-% oder bis zu 60 at-% oder bis zu 70 at-%, bezogen auf das Metall Chrom, vorliegen, nämlich als ein Metalloxid, Metallcarbid, Metallnitrid, Metallcarbonitrid, Metalloxinitrid, Metalloxicarbid, Metalloxicarbonitrid, Metallborid, Metallboronitrid, Metallborocarbid, Metallborocarbonitrid, Metallborooxinitrid, Metallborooxocarbid, Metallborooxocarbonitrid, Metalloxoboronitrid, Metallsilicat oder Gemisch davon, vorzugsweise als Chromnitrid.

4. Verfahren zum Abscheiden von Mischkristallschichten aus Aluminium-Chrom-Oxid auf einem Substrat mittels Lichtbogenverdampfen, **dadurch gekennzeichnet, dass** man in dem Verfahren wenigstens ein Target nach einem der vorangehenden Ansprüche verwendet.

5. Target für das Abscheiden von Mischkristallschichten aus Aluminium-Chrom-Oxid auf einem Substrat mittels Lichtbogenverdampfen, wobei das Target aus Aluminiumoxid und einer Kombination aus elementarem Chrom und einer keramischen Verbindung von Chrom besteht, wobei das Chrom in dem Target neben der elementaren Form in einem Anteil von bis zu 70 at-%, bezogen auf das Metall Chrom, in einer keramischen Verbindung vorliegt, nämlich als ein Metalloxid, Metallcarbid, Metallnitrid, Metallcarbonitrid, Metalloxinitrid, Metalloxicarbid, Metalloxicarbonitrid, Metallborid, Metallboronitrid, Metallborocarbid, Metallborocarbonitrid, Metallborooxinitrid, Metallborooxocarbid, Metallborooxocarbonitrid, Metalloxoboronitrid, Metallsilicat oder Gemisch davon, vorzugsweise als Chromnitrid, oder wobei das Target aus Aluminiumnitrid und elementarem Chrom besteht.

## Claims

1. Use of a target, which consists of aluminium oxide and elemental chromium or of aluminium nitride and elemental chromium or of aluminium oxide and a combination of elemental chromium and a ceramic compound of chromium, for the deposition of mixed crystal layers of aluminium chromium oxide on a substrate by means of arc vapour deposition.

2. Use according to claim 1 **characterised in that** the aluminium present in the target in one of the ceramic compounds aluminium oxide or aluminium nitride is present in the target in an amount of from 2 to 99 atomic %, preferably from 5 to 90 atomic % or from 10 to 80 atomic % or from 20 to 70 atomic % or from 30 to 60 atomic %.

3. Use according to one of the preceding claims **characterised in that** the chromium in the target, if it is present in a ceramic compound besides the elemental form, is present in an amount of up to 10 atomic % or up to 20 atomic % or up to 30 atomic % or up to 40 atomic % or up to 50 atomic % or up to 60 atomic % or up to 70 atomic % with respect to the metal chromium, namely in the form of a metal oxide, metal carbide, metal nitride, metal oxycarbide, metal oxycarbonitride, metal boride, metal boronitride, metal borocarbide, metal borocarbonitride, metal borooxynitride, metal borooxocarbide, metal borooxocarbonitride, metal oxoboronitride, metal silicate or a mixture thereof, preferably in the form of chromium nitride.

4. A method of depositing mixed crystal layers of aluminium chromium oxide on a substrate by means of arc vapour deposition, **characterised in that** at least one target according to one of the preceding claims is used in the method.

5. A target for the deposition of mixed crystal layers made of aluminium chromium oxide on a substrate by means of arc vapour deposition, wherein the target consists of aluminium oxide and a combination of elemental chromium and a ceramic compound of chromium, wherein the chromium in the target besides the elemental form is present in a ceramic compound in an amount of up to 70 atom % with respect to the metal chromium, namely in the form of a metal oxide, metal carbide, metal nitride, metal carbonitride, metal oxynitride, metal oxycarbide, metal oxycarbonitride, metal boride, metal boronitride, metal borocarbide, metal borocarbonitride, metal borooxynitride, metal borooxocarbide, metal borooxocarbonitride, metal oxoboronitride, metal silicate or a mixture thereof, preferably in the form of chromium nitride, or wherein the target consists of aluminium nitride and elemental chromium.

## Revendications

1. Utilisation d'une cible qui est constituée d'oxyde d'aluminium et de chrome élémentaire ou de nitrure d'aluminium et de chrome élémentaire ou d'oxyde d'aluminium et d'une combinaison de chrome élémentaire et d'un composé céramique de chrome, pour le dépôt de couches de mélanges de cristaux d'oxyde d'aluminium et de chrome sur un substrat par évaporation à l'arc électrique.

2. Utilisation selon la revendication 1, **caractérisée en ce que** l'aluminium, présent dans la cible dans un des composés céramiques, oxyde d'aluminium ou nitrure d'aluminium, est présent dans la cible dans une quantité allant de 2 à 99 at-%, de préférence de 5 à 90 at-% ou de 10 à 80 at-% ou de 20 à 70 at-% ou 30 à 60 at-%.

3. Utilisation selon l'une des revendications précédentes, **caractérisée en ce que** le chrome dans la cible, lorsqu'il est présent, en plus de la forme élémentaire, également dans un composé céramique, est présent dans une proportion allant jusqu'à 10 at-% ou jusqu'à 20 at-% ou jusqu'à 30 at-% ou jusqu'à 40 at-% ou jusqu'à 50 at-% ou jusqu'à 60 at-% ou jusqu'à 70 at-%, par rapport au métal chrome, à savoir en tant qu'oxyde de métal, carbure de métal, nitrure de métal, carbonitrure de métal, oxynitrure de métal, oxycarbure de métal, oxycarbonitrure de métal, borure de métal, boronitrure de métal, borocarbure de métal, borocarbonitrure de métal, boro-oxynitrure de métal, boro-oxycarbure de métal, boro-oxycarbonitrure de métal, oxyboronitrure de métal, silicate de métal ou leur mélange, de préférence comme nitrure de chrome.

4. Procédé de dépôt de couches de mélanges de cristaux d'oxyde d'aluminium et de chrome sur un substrat par évaporation à l'arc électrique selon l'une des revendications 1 à 3, **caractérisé en ce que** l'on utilise dans ce procédé au moins une cible selon l'une des revendications précédentes.

5. Cible pour le dépôt de couches de mélanges de cristaux d'oxyde d'aluminium et de chrome sur un substrat par évaporation à l'arc électrique, la cible étant constituée d'oxyde d'aluminium et d'une combinaison de chrome élémentaire et d'un composé céramique de chrome, le chrome étant présent dans cette cible, en plus de la forme élémentaire, dans une proportion allant jusqu'à 70 at-%, par rapport au métal chrome, dans une combinaison céramique, à savoir en tant qu'oxyde de métal, carbure de métal, nitrure de métal, carbonitrure de métal, oxynitrure de métal, oxycarbure de métal, oxycarbonitrure de métal, borure de métal, boronitrure de métal, borocarbure de métal, borocarbonitrure de métal, boro-oxynitrure de métal, boro-oxycarbure de métal, boro-oxycarbonitrure de métal, oxyboronitrure de métal, silicate de métal ou leur mélange, de préférence comme nitrure de chrome, ou la cible étant constitué de nitrure d'aluminium et de chrome élémentaire.
